# EUROPEAN PATENT SPECIFICATION

(11) **EP 4 431 827 B1**
(45) Date of publication and mention of the grant of the patent: **29.04.2026**
(21) Application number: 24163184.5
(22) Date of filing: 13.03.2024
(51) Int. Cl.: F24F 11/84, F24F 11/83, F24F 5/00, F24F 3/14

(54) **COOLING SYSTEM AND PRETREATMENT MODULE THEREFOR**
KÜHLSYSTEM UND VORBEHANDLUNGSMODUL DAFÜR
SYSTÈME DE REFROIDISSEMENT ET MODULE DE PRÉTRAITEMENT ASSOCIÉ

(30) Priority: 13.03.2023 CN 202310265786
(43) Date of publication of application: 18.09.2024
(73) Proprietor: Carrier Corporation, Palm Beach Gardens, FL 33418 (US)
(72) Inventor: XU, Hui, Shanghai 201206 (CN); SHI, Runfu, Shanghai 201206 (CN)
(74) Representative: Dehns

(56) References cited:
- WO-A1-2022/248995
- US-A- 4 430 864
- US-A1- 2015 107 287
- SHAHZAD MUHAMMAD WAKIL ET AL: "An improved indirect evaporative cooler experimental investigation", APPLIED ENERGY, ELSEVIER SCIENCE PUBLISHERS, GB, vol. 256, 1 October 2019 (2019-10-01), XP085871493, ISSN: 0306-2619, [retrieved on 20191001], DOI: 10.1016/J.APENERGY.2019.113934

## Description

### FIELD OF THE INVENTION

The present invention relates to the field of refrigeration devices, in particular to a pretreatment module (such as for data center heat dissapation) and a cooling system configured with the pretreatment module.

### BACKGROUND OF THE INVENTION

For data center heat dissapation, refrigeration systems are typically equipped with both a mechanical refrigeration device and a natural cooling device. Mechanical refrigeration devices are refrigeration devices based on traditional compressors, while natural cooling devices aim to use ambient air for cooling. When the ambient temperature is relatively low, only natural cooling devices can be adopted to meet the load demand by utilizing the cold air from the outdoor environment. As the ambient temperature increases, natural cooling alone may not be able to meet the cooling demand. In this case, mechanical refrigeration devices and natural cooling devices can be used in combination. As the mechanical refrigeration devices are configured with compressors, the energy consumption of the mechanical refrigeration devices during operation is significantly higher than that of the natural cooling devices.
WO 2022/248995 A1 discloses a hybrid air conditioining system for cooling a chamber. The hybrid system incldues a desiccant-coated heat pump configured to cool, through evaporation and condensation of a refrigerant a first air stream, and an indirect evaporative cooling unit configured to cool a second air stream.

### SUMMARY OF THE INVENTION

The object of at least preferred embodiments of the present invention is to solve or at least alleviate the problems existing in the prior art.

According to some aspects, the object of the present invention is to solve the problem of high energy consumption ratio of air conditioning in existing cooling systems.

According to a first aspect of the invention there is provided a pretreatment module for a cooling system comprising:
a first airflow path and a second airflow path, wherein the first airflow path is provided with a first dehumidification heat exchanger, and the second airflow path is provided with a second dehumidification heat exchanger, where a first end of the first airflow path and a first end of the second airflow path communicate to ambient air; and
a pipeline and valve assembly, wherein a second end of the first airflow path and a second end of the second airflow path are configured to be connected to an air inlet and an air outlet of a natural cooling device of the cooling system through the pipeline and valve assembly;
wherein, the pipeline and valve assembly is configured to switch between a first mode and a second mode;
in the first mode, the pipeline and valve assembly is configured such that the first airflow path communicates to the air inlet, and the second airflow path communicates to the air outlet; and
in the second mode, the pipeline and valve assembly is configured such that the first airflow path communicates to the air outlet, and the second airflow path communicates to the air inlet
wherein the pretreatment module is configured to continuously supply dehumidified ambient air to the natural cooling device.

Optionally, the pretreatment module further comprises an additional pipeline and valve assembly, wherein liquid flow paths of the first dehumidification heat exchanger and the second dehumidification heat exchanger are connected to a first liquid port and a second liquid port of the cooling system through the additional pipeline and valve assembly.

Optionally, the additional pipeline and valve assembly is configured such that in the first mode, the liquid flow path of the first dehumidification heat exchanger communicates with the first liquid port and the second liquid port of the cooling system, and the communication from the liquid flow path of the second dehumidification heat exchanger to the first liquid port or the second liquid port of the cooling system is cut off; and
in the second mode, the liquid flow path of the second dehumidification heat exchanger communicates with the first liquid port and the second liquid port of the cooling system, and the communication from the liquid flow path of the first dehumidification heat exchanger to the first liquid port or the second liquid port of the cooling system is cut off.

Optionally, the pipeline and valve assembly comprises:
a first branch and a second branch respectively connected from the first airflow path to the air inlet and the air outlet;
a third branch and a fourth branch respectively connected from the second airflow path to the air inlet and the air outlet;
wherein, the first branch is provided with a first valve, the second branch is provided with a second valve, the third branch is provided with a third valve, and the fourth branch is provided with a fourth valve; or
a first three-way valve is provided at an intersection of the first airflow path, the first branch, and the second branch, and a second three-way valve is provided at an intersection of the second airflow path, the third branch, and the fourth branch.

Optionally, the additional pipeline and valve assembly comprises:
a first main flow path connected to the first liquid port of the cooling system, a first liquid branch and a second liquid branch respectively connected from the first main flow path to the liquid flow path inlet of the first dehumidification heat exchanger and the liquid flow path inlet of the second dehumidification heat exchanger, a second main flow path connected to the second liquid port of the cooling system, and a third liquid branch and a fourth liquid branch respectively connected from the second main flow path to the liquid flow path outlet of the first dehumidification heat exchanger and the liquid flow path outlet of the second dehumidification heat exchanger;
wherein, one of the first liquid branch and the third liquid branch includes a first shut-off valve, and one of the second liquid branch and the fourth liquid branch includes a second shut-off valve; or
a third three-way valve is provided at an intersection of the first main flow path, the first liquid branch, and the second liquid branch, and a fourth three-way valve is provided at an intersection of the second main flow path, the third liquid branch, and the fourth liquid branch.

Optionally, a first driving device, such as a first pump, is provided on a pipeline near the air inlet, where the first driving device draws ambient air into the natural cooling device.

Optionally, a second driving device, such as a second pump, is provided on a pipeline near the air outlet, where the second driving device discharges air from the natural cooling device to the environment.

Optionally, either the first main flow path or the second main flow path includes a third driving device, such as a third pump, where the third driving device drives the liquid cooling medium to circulate.

According to a second aspect of the invention there is provided a cooling system comprising: a pretreatment module (e.g. as described above) and a natural cooling device connected to the pretreatment module, wherein the natural cooling device comprises a direct evaporative cooling device and/or an indirect evaporative cooling device.

Optionally, the natural cooling device is configured to cool air entering from the air inlet through direct evaporative cooling and indirect evaporative cooling with the liquid cooling medium from the second liquid port and transport the air to a load.

Optionally, the natural cooling device is configured to cool liquid cooling medium from the second liquid port through direct evaporative cooling with the air entering from the air inlet and transport the liquid cooling medium to the load.

Optionally, the natural cooling device comprises: a direct evaporative cooling device and an indirect evaporative cooling device, wherein, the liquid cooling medium from the second liquid port sequentially passes through the direct evaporative cooling device and the indirect evaporative cooling device, and is circulated from the first liquid port to the liquid flow path of one of the first dehumidification heat exchanger and the second dehumidification heat exchanger, and absorbing the adsorption heat generated during the dehumidification, where a first part of the airflow from the air inlet is cooled by passing through a dry channel of the indirect evaporative cooling device and is transported to the load, a second part of the airflow from the air inlet or ambient air is discharged after heat and mass exchange with the liquid cooling medium in the direct evaporative cooling device, and a third part of the airflow from the air inlet or ambient air is discharged after heat and mass exchange with the liquid cooling medium in a wet channel of the indirect evaporative cooling device.

Optionally, the natural cooling device comprises: a first direct evaporative cooling device and a second direct evaporative cooling device, wherein, the liquid cooling medium from the second liquid port is transported to the load after sequentially passing through the first direct evaporative cooling device and the second direct evaporative cooling device, and then is circulated from the first liquid port to the liquid flow path of one of the first dehumidification heat exchanger and the second dehumidification heat exchanger to absorb the adsorption heat generated during the dehumidification, where the ambient air or a part of the airflow from the air inlet is discharged after heat and mass exchange with the liquid cooling medium in the first direct evaporative cooling device, and the airflow from the air inlet is discharged after heat and mass exchange with the liquid cooling medium in the second direct evaporative cooling device.

Optionally, the cooling system further comprises: a mechanical refrigeration device comprising a compressor, a condenser, a throttling device, and an evaporator connected in sequence.

Optionally, the cooling system is capable of operating in a natural cooling mode, an auxiliary natural cooling mode, a collaborative refrigeration mode, or a mechanical refrigeration mode, where only the natural cooling device is in operation in the natural cooling mode, the pretreatment module and the natural cooling device operate together in the auxiliary natural cooling mode, the pretreatment module, the natural cooling device, and the mechanical refrigeration device operate together in the collaborative refrigeration mode, and only the mechanical refrigeration device is in operation in the mechanical refrigeration mode.

Optionally, the cooling system determines the operating mode based on ambient temperature and humidity.

Optionally, the air heated by the load is mixed with optional ambient air, and is then transported to the first dehumidification heat exchanger or the second dehumidification heat exchanger after passing through a condenser in the mechanical refrigeration device.

Optionally, when in operation, the pretreatment module periodically switches between the first mode and the second mode.

The pretreatment module and cooling system according to embodiments of the present invention can improve the overall efficiency of the cooling system and reduce its overall energy consumption.

### BRIEF DESCRIPTION OF THE DRAWINGS

With reference to the accompanying drawings, certain exemplary embodiments will now be described in greater detail by way of example only so that the present invention will become easier to understand. Those skilled in the art would easily understand that these drawings are for the purpose of illustration, and are not intended to limit the scope of protection which is defined by the claims. In addition, in the figures, similar numerals are used to denote similar components, where:
FIGS. 1 and 2 respectively show the schematic diagrams of a cooling system when the pretreatment module is in the first mode and the second mode;
FIG. 3 shows a schematic diagram of another cooling system;
FIG. 4 shows a schematic diagram of yet another cooling system;
FIGS. 5 to 7 show the schematic diagrams of direct evaporative cooling and indirect evaporative cooling, as well as the temperature and humidity curves.

### DETAILED DESCRIPTION OF EMBODIMENT(S) OF THE INVENTION

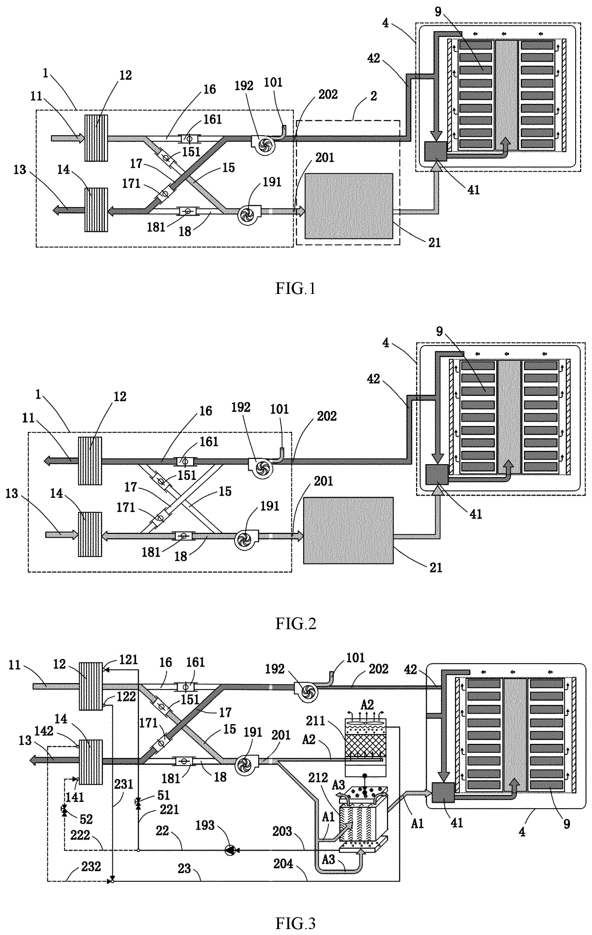

Referring to FIGS. 1 and 2, a cooling system is shown. The cooling system comprises a pretreatment module 1 and a natural cooling device 2 connected to the pretreatment module 1, wherein the natural cooling device 2 is a device based on direct evaporative cooling and/or indirect evaporative cooling for cooling a load 4. In the illustrated embodiment, the load 4 is a data center machine room that includes a plurality of servers 9. Alternatively, the load 4 can be any other device that requires heat dissipation on a long-term basis. When the ambient temperature is sufficiently low, such as in winter, the natural cooling device 2 can be directly adopted to meet the heat dissipation needs of the load 4. For example, ambient air can first be cooled through direct or indirect evaporative cooling in the natural cooling device 2, and then provided to a mixing box 41 in the machine room 4 for circulation in the machine room 4, while the hot air in the machine room 4 is discharged through an outlet channel 42. However, as the ambient temperature increases, the natural cooling device 2 alone may not be able to meet the heat dissipation needs of the machine room 4. In this case, the pretreatment module 1 according to an embodiment of the present invention can be activated to dehumidify the ambient air and supply the dehumidified ambient air to the natural cooling device 2, so as to reduce the temperature of the cooling medium provided to the load 4 through the natural cooling device 2, improve the cooling capacity of the natural cooling device 2, and broaden the applicable ambient temperature and humidity range of the natural cooling device 2, thereby reducing the overall energy consumption of the cooling system.

The pretreatment module 1 comprises: a first airflow path 11, a second airflow path 13, and a pipeline and valve assembly. The first airflow path 11 is provided with a first dehumidification heat exchanger 12, and the second airflow path 13 is provided with a second dehumidification heat exchanger 14. The first end of the first airflow path 11 and the first end of the second airflow path 13 communicate with the ambient air. The second end of the first airflow path 11 and the second end of the second airflow path 13 are connected to an air inlet 201 and an air outlet 202 of the natural cooling device of the cooling system through the pipeline and valve assembly. The pipeline and valve assembly is configured to switch between a first mode as shown in FIG. 1 and a second mode as shown in FIG. 2. In the first mode, the pipeline and valve assembly is configured such that the first airflow path 11 communicates with the air inlet 201 of the cooling system, and the second airflow path 13 communicates with the air outlet 202 of the cooling system. And, in the second mode, the pipeline and valve assembly is configured such that the first airflow path 11 communicates with the air outlet 202 of the cooling system, and the second airflow path 13 communicates with the air inlet 201 of the cooling system. Through this arrangement, one of the first dehumidification heat exchanger 12 and the second dehumidification heat exchanger 14 can be used to reduce the humidity of the introduced ambient air, while the other can be regenerated through the hot air from the load, that is, to remove the moisture adsorbed by the dehumidification heat exchanger and restore its ability to absorb moisture again. Specifically, in the first mode, the first dehumidification heat exchanger 12 plays a dehumidification role, while the second dehumidification heat exchanger 14 is regenerated using the hot air from the load to remove the moisture adsorbed therein. Whereas, in the second mode, the second dehumidification heat exchanger 14 plays a dehumidification role, while the first dehumidification heat exchanger 12 is regenerated using the hot air from the load to remove the moisture adsorbed therein. Therefore, by switching the pretreatment module 1 between the first mode and the second mode, it can be ensured that the pretreatment module 1 continuously supplies dehumidified ambient air to the natural cooling device 2.

In the embodiment shown in the figures, the pipeline and valve assembly comprises: a first branch 15 and a second branch 16 respectively connected from the first airflow path 11 to the air inlet 201 and the air outlet 202, where a first valve 151 and a second valve 161 are respectively provided on the first branch 15 and the second branch 16; and a third branch 18 and a fourth branch 17 respectively connected from the second airflow path 13 to the air inlet 201 and the air outlet 202, where a third valve 181 and a fourth valve 171 are respectively provided on the third branch 18 and the fourth branch 17. Through this arrangement, the switching between the first mode and the second mode can be achieved by controlling the open and close of the first valve, second valve, third valve and fourth valve. For example, in the first mode shown in FIG. 1, the first valve 151 and the fourth valve 171 are opened, and the second valve 161 and the third valve 181 are closed. Whereas, in the second mode shown in FIG. 2, the first valve 151 and the fourth valve 171 are opened, and the second valve 161 and the third valve 181 are closed. Alternatively, the four valves can be replaced by the following arrangement, that is, a first three-way valve is provided at the intersection of the first airflow path 11, the first branch 15 and the second branch 16, and a second three-way valve is provided at the intersection of the second airflow path 13, the third branch 17 and the fourth branch 18. Switching between the first mode and the second mode can also be achieved by controlling the first three-way valve and the second three-way valve. In a further alternative embodiment, the pipeline and valve assembly can have any other suitable arrangement different from that shown in the figures. For example, switching between the first mode and the second mode can be achieved by only configuring a single four-way valve.

With continued reference to FIG. 3, the pretreatment module further comprises an additional pipeline and valve assembly. The liquid flow paths of the first dehumidification heat exchanger 12 and the second dehumidification heat exchanger 14 are connected to the first liquid port 203 and the second liquid end 204 of the natural cooling device of the cooling system through the additional pipeline and valve assembly. The additional pipeline and valve assembly is configured such that in the first mode, the liquid flow path of the first dehumidification heat exchanger 12 communicates with the first liquid port 203 and the second liquid port 204 of the cooling system, and the communication from the liquid flow path of the second dehumidification heat exchanger 14 to the first liquid port 203 and/or the second liquid port 204 of the cooling system is cut off. In the second mode, the liquid flow path of the second dehumidification heat exchanger 14 communicates with the first liquid port 203 and the second liquid port 204 of the cooling system, and the communication from the liquid flow path of the first dehumidification heat exchanger 12 to the first liquid port 203 and/or the second liquid port 204 of the cooling system is cut off.

In the specific embodiment shown in the figure, the additional pipeline and valve assembly comprises: a first main flow path 22 connected to the first liquid port 203 of the cooling system, a first liquid branch 221 and a second liquid branch 222 respectively connected from the first main flow path 22 to the liquid flow path inlet 121 of the first dehumidification heat exchanger 12 and the liquid flow path inlet 141 of the second dehumidification heat exchanger 14, a second main flow path 23 connected to the second liquid port 204 of the cooling system, and a third liquid branch 231 and a fourth liquid branch 232 respectively connected from the second main flow path 23 to the liquid flow path outlet 122 of the first dehumidification heat exchanger 12 and the liquid flow path outlet 142 of the second dehumidification heat exchanger 14. The first liquid branch 221 and the second liquid branch 222 are respectively provided with a first shut-off valve 51 and a second shut-off valve 52. Alternatively, the first shut-off valve 51 can be provided on the third liquid branch 231. Likewise, the second shut-off valve 52 can be provided on the fourth liquid branch 232. In the first mode, the first shut-off valve 51 is opened while the second shut-off valve 52 is closed. Whereas, in the second mode, the first shut-off valve 51 is closed while the second shut-off valve 52 is opened. In alternative embodiments, a third three-way valve is provided at the intersection of the first main flow path 22, the first liquid branch 221, and the second liquid branch 222, and a fourth three-way valve is provided at the intersection of the second main flow path 23, the third liquid branch 231, and the fourth liquid branch 232. In alternative embodiments, a single four-way valve can also be used to replace two three-way valves. Through this arrangement, the cooling medium flowing through the dehumidification heat exchanger absorbs the adsorption heat generated during the dehumidification, which can further reduce the temperature of the air entering the natural cooling device.

In some embodiments, a first driving device, such as a first pump 191, is provided on the pipeline near the air inlet 201, where the first driving device draws ambient air into the natural cooling device. In some embodiments, a second driving device, such as a second pump 192, is provided on the pipeline near the air outlet 202, where the second driving device discharges air from the natural cooling device to the environment. In some embodiments, one of the first main flow path 22 and the second main flow path 23 includes a third driving device, such as a third pump 193, where the third driving device drives the liquid cooling medium to circulate.

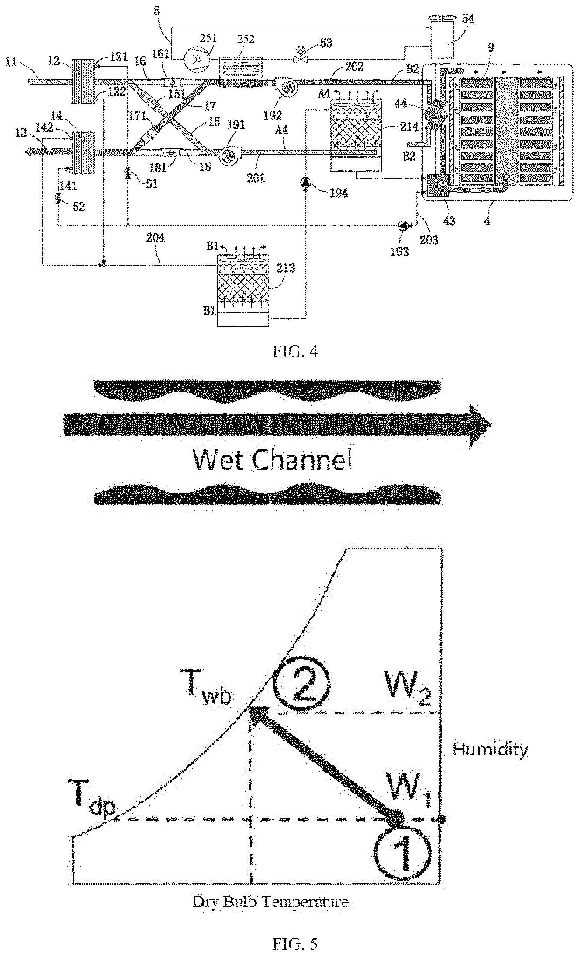

According to another aspect, there is also provided a cooling system, comprising: the pretreatment module 1 according to the various embodiments, and a natural cooling device 2 connected to the pretreatment module 1, wherein the natural cooling device 2 comprises a direct evaporative cooling device and/or an indirect evaporative cooling device. The natural cooling device 2 is configured to cool the air entering from the air inlet 201 through direct evaporative cooling and indirect evaporative cooling with the liquid cooling medium from the second liquid port 204 and transport the air to the load 4, as is described in detail below in conjunction with FIG. 3, or to cool the liquid cooling medium from the second liquid port 204 through direct evaporative cooling with the air entering from the air inlet 201 and transport the liquid cooling medium to the load 4, as is described in detail below in conjunction with FIG. 4.

In some embodiments, the natural cooling device comprises: a direct evaporative cooling device 211 and an indirect evaporative cooling device 212. The liquid cooling medium from the second liquid port 204 of the cooling system sequentially passes through the direct evaporative cooling device 211 and the indirect evaporative cooling device 212, and is circulated from the first liquid port 203 to the liquid flow path of one of the first dehumidification heat exchanger 12 and the second dehumidification heat exchanger 14 that is in a dehumidification operation, absorbing the adsorption heat generated during the dehumidification. In addition, a first part A1 of the airflow from the air inlet 201 is cooled by passing through the dry channel of the indirect evaporative cooling device 212 and is transported to the load 4. A second part A2 of the airflow from the air inlet is discharged after heat and mass exchange with the liquid cooling medium in the direct evaporative cooling device 211, i.e., discharged to the environment or other suitable places, thereby obtaining cooling medium at a lower temperature. And, a third part A3 of the airflow from the air inlet is discharged after heat and mass exchange with the low-temperature cooling medium from the direct evaporative cooling device 211 in the wet channel of the indirect evaporative cooling device 212. In alternative embodiments, ambient air can be used to heat and mass exchange with liquid cooling medium in the direct evaporative cooling device 211 and the indirect evaporative cooling device 212 and then be discharged, or ambient air can be used in the direct evaporative cooling device 211 and a part of the airflow from the air inlet 201 can be used in the indirect evaporative cooling device 212. In the embodiment shown in FIG. 3, low-temperature cooling medium can be obtained through the direct evaporative cooling device 211, where the low-temperature cooling medium is used to reduce the temperature of the first part A1 of the airflow in the indirect evaporative cooling device 212.

With continued reference to FIG. 4, another embodiment of the natural cooling device 2 is shown. In the embodiment of FIG. 4, the natural cooling device 2 comprises: a first direct evaporative cooling device 213 and a second direct evaporative cooling device 214. The liquid cooling medium from the second liquid port 204 is transported to the load 4 after sequentially passing through the first direct evaporative cooling device 213 and the second direct evaporative cooling device 214, and then is circulated from the first liquid port 203 to the liquid flow path of one of the first dehumidification heat exchanger 12 and the second dehumidification heat exchanger 14 that is in a dehumidification operation, absorbing the adsorption heat generated. The ambient air B1 or alternatively a part of the airflow A4 from the air inlet can be introduced to the first direct evaporative cooling device 213 for heat and mass exchange with the liquid cooling medium and then be discharged. And, the airflow A4 (partially or entirely) from the air inlet is discharged after heat and mass exchange with the liquid cooling medium in the second direct evaporative cooling device 214. In the illustrated embodiment, a fourth pump 194 is provided between the first direct evaporative cooling device 213 and the second direct evaporative cooling device 214. In addition, due to the use of liquid cooling medium to cool the load 4, a machine room air treater 43 is arranged at the load 4, and the hot air flow for regeneration of the dehumidification heat exchanger is generated by using the ambient air B2 to exchange heat with the load 4 at the heat exchanger 44. It should be appreciated that the natural cooling device 2 in FIGS. 3 or 4 is only illustrative, and in alternative embodiments, the natural cooling device 2 may have other suitable structures.

According to yet another aspect, FIG. 4 also illustrates a mechanical refrigeration device 5 in the cooling system, which is activated when the heat dissipation demand of the load 4 cannot be met when both the natural cooling device 2 and the pretreatment module 1 operate together. The mechanical refrigeration device 5 is a conventional compressor-based refrigeration loop, which includes a compressor 251, a condenser 252, a throttling device 53, and an evaporator 54 connected in sequence, wherein the evaporator 54 is used to cool the load 4. Therefore, the cooling system according to the embodiments of the present invention can operate in any of the natural cooling mode, auxiliary natural cooling mode, collaborative refrigeration mode, or mechanical refrigeration mode. In the natural cooling mode, only the natural cooling device 2 is in operation. In the auxiliary natural cooling mode, the pretreatment module 1 and natural cooling device 2 operate together. In the collaborative refrigeration mode, the pretreatment module 1, natural cooling device 2, and mechanical refrigeration device 5 operate together. In the mechanical refrigeration mode, the mechanical refrigeration device 5 operates alone. In some embodiments, the operating mode of the cooling system is determined based on ambient temperature and humidity. The enthalpy-humidity chart of humid air may include four regions corresponding to the four operating modes, where the mode to be executed is determined based on which region the actual ambient temperature and humidity locate in. In addition, in some embodiments, as shown in FIG. 3, the air heated by the load 4 can be mixed with the ambient air 101 before being transported to the first or second dehumidification heat exchanger to increase the flow amount of the airflow used for regeneration. In some embodiments, as shown in FIG. 4, the ambient airflow B2 heated by the load 4 can be adopted and transported to the first dehumidification heat exchanger or the second dehumidification heat exchanger after passing through the condenser 252 in the mechanical refrigeration device 5. Through this arrangement, the temperature of the airflow used for regeneration can be further increased when the condenser 252 is operating, thereby improving the speed and adequacy of regeneration, so as to remove the moisture absorbed by the dehumidification heat exchanger more quickly and thoroughly. Furthermore, the pretreatment module 1 can periodically switch between the first mode and the second mode when it is activated, where the switching frequency can be determined based on the ambient temperature and humidity, the temperature and humidity of regeneration air, the regeneration rate, the dehumidification effect and the like.

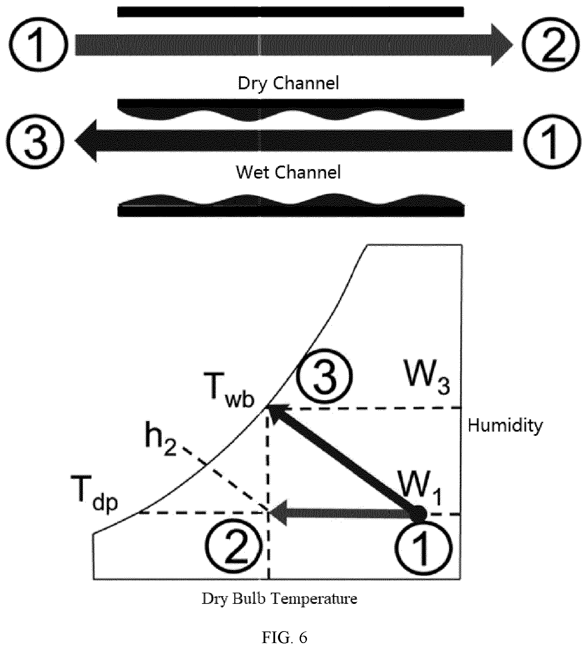

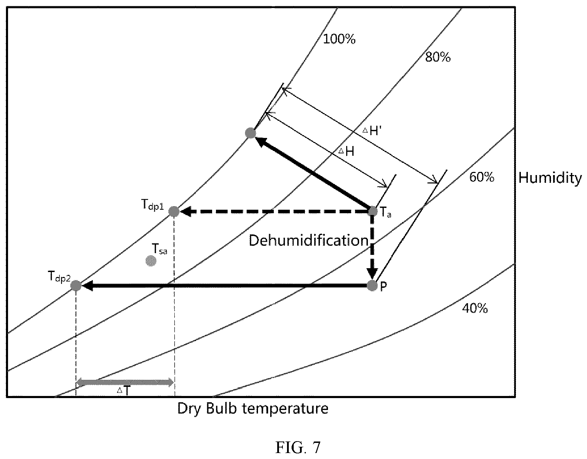

With continued reference to FIGS. 5 to 7, the principles of direct evaporative cooling and indirect evaporative cooling, as well as the impact of dehumidification on direct and indirect evaporative coolings are introduced. As shown in FIG. 5, direct evaporative cooling refers to the direct contact between air and cooling medium, such as water, in the pipeline, which can increase the humidity of the air and decrease its temperature, thus reaching the temperature T_{wb} as shown by the arrow in the figure. With continued reference to FIG. 6, in indirect evaporative cooling, air and cooling medium, such as water, come into direct contact in the pipeline in a wet channel, which can increase the humidity and decrease the temperature of the air, while the airflow in another dry channel exchanges heat with the fluid in the wet channel, thereby reducing the temperature while keeping the humidity constant. The minimum temperature T_{dp} that can be achieved through indirect evaporative cooling depends on the humidity of the airflow in the dry channel. Referring to FIG. 7, after dehumidification, the ambient air can be further reduced to a minimum temperature of T_{dp2} from T_{dp1} through indirect evaporative cooling. Similarly, the minimum temperature that can be achieved through direct evaporative cooling also decreases as a result of decreasing humidity. This enables the supply airflow with lower humidity to reach lower temperatures when using the same natural cooling device, which enbales it to handle larger loads or higher ambient temperatures while the load remains constant. Specifically, when the temperature required for heat dissipation for the load is Tₛₐ, the minimum temperature T_{dp1} that can be achieved by indirect evaporative cooling of air without dehumidification treatment cannot meet the demand, while the minimum temperature T_{dp2} lower than T_{dp1} of the air after dehumidification treatment can meet the demand of the load. Therefore, by using the device according to the embodiments of the present invention, when as the ambient temperature rises, it is possible to use the natural cooling device as long as possible and activate the mechanical refrigeration device with higher energy comsumption as late as possible, thereby reducing the overall energy consumption of the cooling system and improving its overall efficiency.

The specific embodiments described above in the present disclosure are merely intended to describe the principles of the present invention more clearly, wherein various components are clearly shown or described to facilitate the understanding of the principles of the present invention. Those skilled in the art may, without departing from the scope of the present invention as defined by the claims, make various modifications or changes.

## Claims

1. A pretreatment module (1) for a cooling system, comprising:
a first airflow path (11) and a second airflow path (13), wherein the first airflow path is provided with a first dehumidification heat exchanger (12), and the second airflow path is provided with a second dehumidification heat exchanger (14), where a first end of the first airflow path and a first end of the second airflow path communicate with ambient air; and
a pipeline and valve assembly, wherein a second end of the first airflow path and a second end of the second airflow path are configured to be connected to an air inlet (201) and an air outlet (202) of a natural cooling device (2) of the cooling system through the pipeline and valve assembly;
wherein, the pipeline and valve assembly is configured to switch between a first mode and a second mode;
in the first mode, the pipeline and valve assembly is configured such that the first airflow path communicates to the air inlet, and the second airflow path communicates to the air outlet; and
in the second mode, the pipeline and valve assembly is configured such that the first airflow path communicates to the air outlet, and the second airflow path communicates to the air inlet;
wherein the pretreatment module (1) is configured to continuously supply dehumidified ambient air to the natural cooling device (2).

2. The pretreatment module according to claim 1, wherein the pretreatment module further comprises an additional pipeline and valve assembly, wherein liquid flow paths of the first dehumidification heat exchanger and the second dehumidification heat exchanger are connected to a first liquid port (203) and a second liquid port (204) of the natural cooling device of the cooling system through the additional pipeline and valve assembly;
wherein, the additional pipeline and valve assembly is configured such that in the first mode, the liquid flow path of the first dehumidification heat exchanger comunicates with the first liquid port and the second liquid port of the cooling system, and the communication from the liquid flow path of the second dehumidification heat exchanger to the first liquid port or the second liquid port of the cooling system is cut off; and
in the second mode, the liquid flow path of the second dehumidification heat exchanger communicates with the first liquid port and the second liquid port of the cooling system, and the communication from the liquid flow path of the first dehumidification heat exchanger to the first liquid port or the second liquid port of the cooling system is cut off.

3. The pretreatment module according to claims 1 or 2, wherein the pipeline and valve assembly comprises:
a first branch (15) and a second branch (16) respectively connected from the first airflow path to the air inlet and the air outlet;
a third branch (18) and a fourth branch (17) respectively connected from the second airflow path to the air inlet and the air outlet;
wherein, the first branch is provided with a first valve (151), the second branch is provided with a second valve (161), the third branch is provided with a third valve (181), and the fourth branch is provided with a fourth valve (171); or
a first three-way valve is provided at an intersection of the first airflow path, the first branch, and the second branch, and a second three-way valve is provided at an intersection of the second airflow path, the third branch, and the fourth branch.

4. The pretreatment module according to claims 2 or 3 when dependent on claim 2, wherein the additional pipeline and valve assembly comprises:
a first main flow path (22) connected to the first liquid port of the natural cooling device, a first liquid branch (221) and a second liquid branch (222) respectively connected from the first main flow path to the liquid flow path inlet of the first dehumidification heat exchanger and the liquid flow path inlet of the second dehumidification heat exchanger, a second main flow path (23) connected to the second liquid port of the cooling system, and a third liquid branch (231) and a fourth liquid branch (232) respectively connected from the second main flow path to the liquid flow path outlet of the first dehumidification heat exchanger and the liquid flow path outlet of the second dehumidification heat exchanger;
wherein, one of the first liquid branch and the third liquid branch includes a first shut-off valve (51), and one of the second liquid branch and the fourth liquid branch includes a second shut-off valve (52); or
a third three-way valve is provided at an intersection of the first main flow path, the first liquid branch, and the second liquid branch, and a fourth three-way valve is provided at an intersection of the second main flow path, the third liquid branch, and the fourth liquid branch.

5. The pretreatment module according to any of claims 1 to4, wherein a first driving device, such as a first pump (191), is provided on a pipeline near the air inlet, where the first driving device draws ambient air into the natural cooling device; optionally, a second driving device, such as a second pump (192), is provided on a pipeline near the air outlet, where the second driving device discharges air from the natural cooling device to the environment; optionally, one of the first main flow path and the second main flow path includes a third driving device, such as a third pump (193), where the third driving device drives a liquid cooling medium to circulate.

6. A cooling system, comprising: the pretreatment module (1) according to any of claims 1 to 5 and a natural cooling device (2) connected to the pretreatment module, wherein the natural cooling device comprises a direct evaporative cooling device (211) and/or an indirect evaporative cooling device (212).

7. The cooling system according to claim 6, wherein the natural cooling device is configured to cool the air entering from the air inlet (201) through direct evaporative cooling and indirect evaporative cooling with a liquid cooling medium from the second liquid port (204) and transport the air to a load (4), or to cool liquid cooling medium from the second liquid port through direct evaporative cooling with the air entering from the air inlet and transport the liquid cooling medium to the load.

8. The cooling system according to any of claims 6 or 7, wherein the natural cooling device comprises: a direct evaporative cooling device and an indirect evaporative cooling device, wherein, the liquid cooling medium from the second liquid port sequentially passes through the direct evaporative cooling device and the indirect evaporative cooling device, and then circulates from the first liquid port (203) to the liquid flow path of one of the first dehumidification heat exchanger (12) and the second dehumidification heat exchanger (14), absorbing adsorption heat generated during the dehumidification, where a first part of airflow from the air inlet is cooled by passing through a dry channel of the indirect evaporative cooling device and is transported to the load, a second part of the airflow from the air inlet or ambient air is discharged after heat and mass exchange with the liquid cooling medium in the direct evaporative cooling device, and a third part of the airflow from the air inlet or ambient air is discharged after heat and mass exchange with the liquid cooling medium in a wet channel of the indirect evaporative cooling device.

9. The cooling system according to any of claims 6 or 7, wherein the natural cooling device comprises: a first direct evaporative cooling device (213) and a second direct evaporative cooling device (214), wherein, the liquid cooling medium from the second liquid port is transported to the load after sequentially passing through the first direct evaporative cooling device and the second direct evaporative cooling device, and then circulates from the first liquid port to the liquid flow path of either the first dehumidification heat exchanger or the second dehumidification heat exchanger to absorb the adsorption heat generated during the dehumidification, where ambient air or a part of the airflow from the air inlet is discharged after heat and mass exchange with the liquid cooling medium in the first direct evaporative cooling device, and the airflow from the air inlet is discharged after heat and mass exchange with the liquid cooling medium in the second direct evaporative cooling device.

10. The cooling system according to any of claims 6 to 9, wherein the cooling system further comprises: a mechanical refrigeration device (5) comprising a compressor (251), a condenser (252), a throttling device (53), and an evaporator (54) connected in sequence;
wherein, the cooling system is capable of operating in a natural cooling mode, an auxiliary natural cooling mode, a collaborative refrigeration mode, or a mechanical refrigeration mode, where only the natural cooling device is in operation in the natural cooling mode, the pretreatment module and the natural cooling device operate together in the auxiliary natural cooling mode, the pretreatment module, the natural cooling device, and the mechanical refrigeration device operate together in the collaborative refrigeration mode, and only the mechanical refrigeration device is in operation in the mechanical refrigeration mode;
wherein, the cooling system determines an operating mode based on ambient temperature and humidity;
optionally, air heated by the load is mixed with optional ambient air, and is then transported to the first dehumidification heat exchanger or the second dehumidification heat exchanger after passing through the condenser in the mechanical refrigeration device;
wherein, when in operation, the pretreatment module periodically switches between the first mode and the second mode.

## Patentansprüche

1. Vorbehandlungsmodul (1) für ein Kühlsystem, umfassend:
einen ersten Luftstrompfad (11) und einen zweiten Luftstrompfad (13), wobei der erste Luftstrompfad mit einem ersten Entfeuchtungswärmetauscher (12) versehen ist und der zweite Luftstrompfad mit einem zweiten Entfeuchtungswärmetauscher (14) versehen ist, wobei ein erstes Ende des ersten Luftstrompfads und ein erstes Ende des zweiten Luftstrompfads mit Umgebungsluft in Verbindung stehen; und
eine Rohrleitungs- und Ventilanordnung, wobei ein zweites Ende des ersten Luftstrompfads und ein zweites Ende des zweiten Luftstrompfads ausgelegt sind, um durch die Rohrleitungs- und Ventilanordnung mit einem Lufteinlass (201) und einem Luftauslass (202) einer natürlichen Kühlvorrichtung (2) des Kühlsystems verbunden zu sein;
wobei die Rohrleitungs- und Ventilanordnung ausgelegt ist, um zwischen einem ersten Modus und einem zweiten Modus umzuschalten;
wobei die Rohrleitungs- und Ventilanordnung in dem ersten Modus so ausgelegt ist, dass der erste Luftstrompfad mit dem Lufteinlass in Verbindung steht und der zweite Luftstrompfad mit dem Luftauslass in Verbindung steht; und
wobei die Rohrleitungs- und Ventilanordnung in dem zweiten Modus so ausgelegt ist, dass der erste Luftstrompfad mit dem Luftauslass in Verbindung steht und der zweite Luftstrompfad mit dem Lufteinlass in Verbindung steht;
wobei das Vorbehandlungsmodul (1) ausgelegt ist, um der natürlichen Kühlvorrichtung (2) kontinuierlich entfeuchtete Umgebungsluft zuzuführen.

2. Vorbehandlungsmodul nach Anspruch 1, wobei das Vorbehandlungsmodul ferner eine zusätzliche Rohrleitungs- und Ventilanordnung umfasst, wobei Flüssigkeitsstrompfade des ersten Entfeuchtungswärmetauschers und des zweiten Entfeuchtungswärmetauschers durch die zusätzliche Rohrleitungs- und Ventilanordnung mit einem ersten Flüssigkeitsanschluss (203) und einem zweiten Flüssigkeitsanschluss (204) der natürlichen Kühlvorrichtung des Kühlsystems verbunden sind;
wobei die zusätzliche Rohrleitungs- und Ventilanordnung so ausgelegt ist, dass in dem ersten Modus der Flüssigkeitsstrompfad des ersten Entfeuchtungswärmetauschers mit dem ersten Flüssigkeitsanschluss und dem zweiten Flüssigkeitsanschluss des Kühlsystems in Verbindung steht und die Verbindung von dem Flüssigkeitsstrompfad des zweiten Entfeuchtungswärmetauschers zu dem ersten oder zweiten Flüssigkeitsanschluss des Kühlsystems unterbrochen ist; und
wobei in dem zweiten Modus der Flüssigkeitsstrompfad des zweiten Entfeuchtungswärmetauschers mit dem ersten Flüssigkeitsanschluss und dem zweiten Flüssigkeitsanschluss des Kühlsystems in Verbindung steht und die Verbindung von dem Flüssigkeitsstrompfad des ersten Entfeuchtungswärmetauschers zu dem ersten oder dem zweiten Flüssigkeitsanschluss des Kühlsystems unterbrochen ist.

3. Vorbehandlungsmodul nach Anspruch 1 oder 2, wobei die Rohrleitungs- und Ventilanordnung umfasst:
eine erste Abzweigung (15) und eine zweite Abzweigung (16), die jeweils von dem ersten Luftstrompfad mit dem Lufteinlass und dem Luftauslass verbunden sind;
eine dritte Abzweigung (18) und eine vierte Abzweigung (17), die jeweils von dem zweiten Luftstrompfad mit dem Lufteinlass und dem Luftauslass verbunden sind;
wobei die erste Abzweigung mit einem ersten Ventil (151) versehen ist, die zweite Abzweigung mit einem zweiten Ventil (161) versehen ist, die dritte Abzweigung mit einem dritten Ventil (181) versehen ist und die vierte Abzweigung mit einem vierten Ventil (171) versehen ist; oder
ein erstes Dreiwegeventil an einer Schnittstelle des ersten Luftstrompfads, der ersten Abzweigung und der zweiten Abzweigung vorgesehen ist und ein zweites Dreiwegeventil an einer Schnittstelle des zweiten Luftstrompfads, der dritten Abzweigung und der vierten Abzweigung vorgesehen ist.

4. Vorbehandlungsmodul nach Anspruch 2 oder 3, wenn abhängig von Anspruch 2, wobei die zusätzliche Rohrleitungs- und Ventilanordnung umfasst:
einen ersten Hauptstrompfad (22), der mit dem ersten Flüssigkeitsanschluss der natürlichen Kühlvorrichtung verbunden ist, eine erste Flüssigkeitsabzweigung (221) und eine zweite Flüssigkeitsabzweigung (222), die jeweils von dem ersten Hauptstrompfad zu dem Flüssigkeitsstrompfadeinlass des ersten Entfeuchtungswärmetauschers und zu dem Flüssigkeitsstrompfadeinlass des zweiten Entfeuchtungswärmetauschers verbunden sind, einen zweiten Hauptstrompfad (23), der mit dem zweiten Flüssigkeitsanschluss des Kühlsystems verbunden ist, und eine dritte Flüssigkeitsabzweigung (231) und eine vierte Flüssigkeitsabzweigung (232), die jeweils von dem zweiten Hauptstrompfad zu dem Flüssigkeitsstrompfadauslass des ersten Entfeuchtungswärmetauschers und zu dem Flüssigkeitsstrompfadauslass des zweiten Entfeuchtungswärmetauschers verbunden sind;
wobei eine von der ersten Flüssigkeitsabzweigung und der dritten Flüssigkeitsabzweigung ein erstes Absperrventil (51) aufweist und eine von der zweiten Flüssigkeitsabzweigung und der vierten Flüssigkeitsabzweigung ein zweites Absperrventil (52) aufweist; oder
ein drittes Dreiwegeventil an einer Schnittstelle des ersten Hauptstrompfads, der ersten Flüssigkeitsabzweigung und der zweiten Flüssigkeitsabzweigung vorgesehen ist und ein viertes Dreiwegeventil an einer Schnittstelle des zweiten Hauptstrompfads, der dritten Flüssigkeitsabzweigung und der vierten Flüssigkeitsabzweigung vorgesehen ist.

5. Vorbehandlungsmodul nach einem der Ansprüche 1 bis 4, wobei eine erste Antriebsvorrichtung, wie etwa eine erste Pumpe (191), an einer Rohrleitung in der Nähe des Lufteinlasses vorgesehen ist, wobei die erste Antriebsvorrichtung Umgebungsluft in die natürliche Kühlvorrichtung saugt; optional eine zweite Antriebsvorrichtung, wie etwa eine zweite Pumpe (192), an einer Rohrleitung in der Nähe des Luftauslasses vorgesehen ist, wobei die zweite Antriebsvorrichtung Luft aus der natürlichen Kühlvorrichtung in die Umgebung abgibt; wobei optional einer von dem ersten Hauptstrompfad und dem zweiten Hauptstrompfad eine dritte Antriebsvorrichtung, wie etwa eine dritte Pumpe (193), aufweist, wobei die dritte Antriebsvorrichtung ein flüssiges Kühlmedium zum Zirkulieren antreibt.

6. Kühlsystem, umfassend: das Vorbehandlungsmodul (1) nach einem der Ansprüche 1 bis 5 und eine natürliche Kühlvorrichtung (2), die mit dem Vorbehandlungsmodul verbunden ist, wobei die natürliche Kühlvorrichtung eine direkte Verdunstungskühlvorrichtung (211) und/oder eine indirekte Verdunstungskühlvorrichtung (212) umfasst.

7. Kühlsystem nach Anspruch 6, wobei die natürliche Kühlvorrichtung ausgelegt ist, um die von dem Lufteinlass (201) einströmende Luft durch direkte und indirekte Verdunstungskühlung mit einem flüssigen Kühlmedium aus dem zweiten Flüssigkeitsanschluss (204) zu kühlen und die Luft zu einer Last (4) zu transportieren, oder um das flüssige Kühlmedium aus dem zweiten Flüssigkeitsanschluss durch direkte Verdunstungskühlung mit der von dem Lufteinlass einströmenden Luft zu kühlen und das flüssige Kühlmedium zu der Last zu transportieren.

8. Kühlsystem nach einem der Ansprüche 6 oder 7, wobei die natürliche Kühlvorrichtung umfasst: eine direkte Verdunstungskühlvorrichtung und eine indirekte Verdunstungskühlvorrichtung, wobei das flüssige Kühlmedium aus dem zweiten Flüssigkeitsanschluss nacheinander durch die direkte Verdunstungskühlvorrichtung und die indirekte Verdunstungskühlvorrichtung gelangt und dann von dem ersten Flüssigkeitsanschluss (203) zu dem Flüssigkeitsstrompfad eines von dem ersten Entfeuchtungswärmetauscher (12) und dem zweiten Entfeuchtungswärmetauscher (14) zirkuliert, wobei es Adsorptionswärme absorbiert, die während der Entfeuchtung erzeugt wird, wobei ein erster Teil des Luftstroms aus dem Lufteinlass durch Passieren eines Trockenkanals der indirekten Verdunstungskühlvorrichtung gekühlt wird und zu der Last transportiert wird, ein zweiter Teil des Luftstroms aus dem Lufteinlass oder der Umgebungsluft nach einem Wärme- und Massenaustausch mit dem flüssigen Kühlmedium in der direkten Verdunstungskühlvorrichtung abgegeben wird und ein dritter Teil des Luftstroms aus dem Lufteinlass oder der Umgebungsluft nach einem Wärme- und Massenaustausch mit dem flüssigen Kühlmedium in einem Nasskanal der indirekten Verdunstungskühlvorrichtung abgegeben wird.

9. Kühlsystem nach einem der Ansprüche 6 oder 7, wobei die natürliche Kühlvorrichtung umfasst: eine erste direkte Verdunstungskühlvorrichtung (213) und eine zweite direkte Verdunstungskühlvorrichtung (214), wobei das flüssige Kühlmedium aus dem zweiten Flüssigkeitsanschluss zu der Last transportiert wird, nachdem es nacheinander durch die erste direkte Verdunstungskühlvorrichtung und die zweite direkte Verdunstungskühlvorrichtung gelangt ist, und dann von dem ersten Flüssigkeitsanschluss zu dem Flüssigkeitsstrompfad entweder des ersten Entfeuchtungswärmetauschers oder des zweiten Entfeuchtungswärmetauschers zirkuliert, um Adsorptionswärme zu absorbieren, die während der Entfeuchtung erzeugt wird, wobei Umgebungsluft oder ein Teil des Luftstroms aus dem Lufteinlass nach einem Wärme- und Massenaustausch mit dem flüssigen Kühlmedium in der ersten direkten Verdunstungskühlvorrichtung abgegeben wird und der Luftstrom aus dem Lufteinlass nach einem Wärme- und Massenaustausch mit dem flüssigen Kühlmedium in der zweiten direkten Verdunstungskühlvorrichtung abgegeben wird.

10. Kühlsystem nach einem der Ansprüche 6 bis 9, wobei das Kühlsystem ferner umfasst: eine mechanische Kältevorrichtung (5), die einen Kompressor (251), einen Kondensator (252), eine Drosselvorrichtung (53) und einen Verdampfer (54) umfasst, die in Reihe geschaltet sind;
wobei das Kühlsystem in der Lage ist, in einem natürlichen Kühlmodus, einem zusätzlichen natürlichen Kühlmodus, einem kooperativen Kältemodus oder einem mechanischen Kältemodus zu arbeiten, wobei in dem natürlichen Kühlmodus nur die natürliche Kühleinrichtung in Betrieb ist, in dem zusätzlichen natürlichen Kühlmodus das Vorbehandlungsmodul und die natürliche Kühleinrichtung zusammenarbeiten, in dem kooperativen Kältemodus das Vorbehandlungsmodul, die natürliche Kühleinrichtung und die mechanische Kältevorrichtung zusammenarbeiten und in dem mechanischen Kältemodus nur die mechanische Kältevorrichtung in Betrieb ist;
wobei das Kühlsystem einen Betriebsmodus basierend auf Umgebungstemperatur und -feuchtigkeit bestimmt;
wobei optional die von der Last erwärmte Luft mit optionaler Umgebungsluft vermischt wird und anschließend, nachdem sie durch den Kondensator in der mechanischen Kältevorrichtung gelangt ist, zu dem ersten Entfeuchtungswärmetauscher oder dem zweiten Entfeuchtungswärmetauscher transportiert wird;
wobei das Vorbehandlungsmodul, wenn es im Betrieb ist, periodisch zwischen dem ersten Modus und dem zweiten Modus umschaltet.

## Revendications

1. Module de prétraitement (1) pour un système de refroidissement, comprenant :
un premier trajet d'écoulement d'air (11) et un second trajet d'écoulement d'air (13), dans lequel le premier trajet d'écoulement d'air est pourvu d'un premier échangeur thermique de déshumidification (12), et le second trajet d'écoulement d'air étant pourvu d'un second échangeur thermique de déshumidification (14), une première extrémité du premier trajet d'écoulement d'air et une première extrémité du second trajet d'écoulement d'air étant en communication avec l'air ambiant ; et
un ensemble de conduites et de vannes, dans lequel une seconde extrémité du premier trajet d'écoulement d'air et une seconde extrémité du second trajet d'écoulement d'air est configurées pour être raccordées à une entrée d'air (201) et à une sortie d'air (202) d'un dispositif de refroidissement naturel (2) du système de refroidissement au moyen de l'ensemble de conduites et de vannes ;
dans lequel l'ensemble de conduites et de vannes est configuré pour basculer entre un premier mode et un second mode ;
dans le premier mode, l'ensemble de conduites et de vannes est configuré de sorte que le premier trajet d'écoulement d'air est en communication avec l'entrée d'air, et le second trajet d'écoulement d'air est en communication avec la sortie d'air ; et
dans le second mode, l'ensemble de conduites et de vannes est configuré de sorte que le premier trajet d'écoulement d'air est en communication avec la sortie d'air, et le second trajet d'écoulement d'air est en communication avec l'entrée d'air ;
dans lequel le module de prétraitement (1) est configuré pour fournir en continu de l'air ambiant déshumidifié au dispositif de refroidissement naturel (2).

2. Module de prétraitement selon la revendication 1, dans lequel le module de prétraitement comprend en outre un ensemble additionnel de conduites et de vannes, dans lequel des trajets d'écoulement de liquide du premier échangeur thermique de déshumidification et du second échangeur thermique de déshumidification étant raccordés à un premier orifice de liquide (203) et à un second orifice de liquide (204) du dispositif de refroidissement naturel du système de refroidissement au moyen de l'ensemble additionnel de conduites et de vannes ;
dans lequel l'ensemble additionnel de conduites et de vannes est configuré de sorte que, dans le premier mode, le trajet d'écoulement de liquide du premier échangeur thermique de déshumidification est en communication avec le premier orifice de liquide et le second orifice de liquide du système de refroidissement, et la communication du trajet d'écoulement de liquide du second échangeur thermique de déshumidification vers le premier orifice de liquide ou le second orifice de liquide du système de refroidissement est interrompue ; et
dans le second mode, le trajet d'écoulement de liquide du second échangeur thermique de déshumidification est en communication avec le premier orifice de liquide et le second orifice de liquide du système de refroidissement, et la communication du trajet d'écoulement de liquide du premier échangeur thermique de déshumidification vers le premier orifice de liquide ou le second orifice de liquide du système de refroidissement est interrompue.

3. Module de prétraitement selon la revendication 1 ou 2, dans lequel l'ensemble de conduites et de vannes comprend :
un premier embranchement (15) et un second embranchement (16) raccordés respectivement depuis le premier trajet d'écoulement d'air vers l'entrée d'air et vers la sortie d'air ;
un troisième embranchement (18) et un quatrième embranchement (17) raccordés respectivement depuis le second trajet d'écoulement d'air vers l'entrée d'air et vers la sortie d'air ;
dans lequel le premier embranchement est pourvu d'une première vanne (151), le second embranchement est pourvu d'une seconde vanne (161), le troisième embranchement est pourvu d'une troisième vanne (181), et le quatrième embranchement est pourvu d'une quatrième vanne (171) ; ou
une première vanne à trois voies est disposée à une intersection du premier trajet d'écoulement d'air, du premier embranchement et du second embranchement, et une seconde vanne à trois voies est disposée à une intersection du second trajet d'écoulement d'air, du troisième embranchement et du quatrième embranchement.

4. Module de prétraitement selon la revendication 2 ou 3 lorsque dépendant de la revendication 2, dans lequel l'ensemble additionnel de conduites et de vannes comprend :
un premier trajet principal d'écoulement (22) raccordé au premier orifice de liquide du dispositif de refroidissement naturel, une première branche de liquide (221) et une seconde branche de liquide (222) raccordées respectivement depuis le premier trajet principal d'écoulement vers l'entrée du trajet d'écoulement de liquide du premier échangeur thermique de déshumidification et vers l'entrée du trajet d'écoulement de liquide du second échangeur thermique de déshumidification, un second trajet principal d'écoulement (23) raccordé au second orifice de liquide du système de refroidissement, et une troisième branche de liquide (231) et une quatrième branche de liquide (232) raccordées respectivement depuis le second trajet principal d'écoulement vers la sortie du trajet d'écoulement de liquide du premier échangeur thermique de déshumidification et vers la sortie du trajet d'écoulement de liquide du second échangeur thermique de déshumidification ;
dans lequel l'une de la première branche de liquide et de la troisième branche de liquide comporte une première vanne d'arrêt (51), et l'une de la seconde branche de liquide et de la quatrième branche de liquide comporte une seconde vanne d'arrêt (52) ; ou
une troisième vanne à trois voies est disposée à une intersection du premier trajet principal d'écoulement, de la première branche de liquide et de la seconde branche de liquide, et une quatrième vanne à trois voies est disposée à une intersection du second trajet principal d'écoulement, de la troisième branche de liquide et de la quatrième branche de liquide.

5. Module de prétraitement selon l'une quelconque des revendications 1 à 4, dans lequel un premier dispositif d'entraînement, tel qu'une première pompe (191), est disposé sur une conduite à proximité de l'entrée d'air, le premier dispositif d'entraînement aspirant l'air ambiant dans le dispositif de refroidissement naturel ; éventuellement, un second dispositif d'entraînement, tel qu'une seconde pompe (192), est disposé sur une conduite à proximité de la sortie d'air, le second dispositif d'entraînement évacuant l'air depuis le dispositif de refroidissement naturel vers l'environnement ; éventuellement, l'un du premier trajet principal d'écoulement et du second trajet principal d'écoulement comporte un troisième dispositif d'entraînement, tel qu'une troisième pompe (193), le troisième dispositif d'entraînement entraînant un fluide caloporteur liquide à circuler.

6. Système de refroidissement, comprenant : le module de prétraitement (1) selon l'une quelconque des revendications 1 à 5 et un dispositif de refroidissement naturel (2) raccordé au module de prétraitement, dans lequel le dispositif de refroidissement naturel comprend un dispositif de refroidissement évaporatif direct (211) et/ou un dispositif de refroidissement évaporatif indirect (212).

7. Système de refroidissement selon la revendication 6, dans lequel le dispositif de refroidissement naturel est configuré pour refroidir l'air entrant depuis l'entrée d'air (201) par refroidissement évaporatif direct et refroidissement évaporatif indirect avec un fluide caloporteur liquide provenant du second orifice de liquide (204) et acheminer l'air vers une charge (4), ou pour refroidir le fluide caloporteur liquide provenant du second orifice de liquide par refroidissement évaporatif direct avec l'air entrant depuis l'entrée d'air et acheminer le fluide caloporteur liquide vers la charge.

8. Système de refroidissement selon l'une quelconque des revendications 6 ou 7, dans lequel le dispositif de refroidissement naturel comprend : un dispositif de refroidissement évaporatif direct et un dispositif de refroidissement évaporatif indirect, dans lequel le fluide caloporteur liquide provenant du second orifice de liquide passe séquentiellement à travers le dispositif de refroidissement évaporatif direct et le dispositif de refroidissement évaporatif indirect, puis circule depuis le premier orifice de liquide (203) vers le trajet d'écoulement de liquide de l'un du premier échangeur thermique de déshumidification (12) et du second échangeur thermique de déshumidification (14), en absorbant une chaleur d'adsorption générée pendant la déshumidification, une première partie d'un flux d'air provenant de l'entrée d'air étant refroidie en passant à travers un canal sec du dispositif de refroidissement évaporatif indirect et étant acheminée vers la charge, une seconde partie du flux d'air provenant de l'entrée d'air ou de l'air ambiant étant évacuée après échange de chaleur et de masse avec le fluide caloporteur liquide dans le dispositif de refroidissement évaporatif direct, et une troisième partie du flux d'air provenant de l'entrée d'air ou de l'air ambiant étant évacuée après échange de chaleur et de masse avec le fluide caloporteur liquide dans un canal humide du dispositif de refroidissement évaporatif indirect.

9. Système de refroidissement selon l'une quelconque des revendications 6 ou 7, dans lequel le dispositif de refroidissement naturel comprend : un premier dispositif de refroidissement évaporatif direct (213) et un second dispositif de refroidissement évaporatif direct (214), dans lequel le fluide caloporteur liquide provenant du second orifice de liquide est acheminé vers la charge après passage séquentiel à travers le premier dispositif de refroidissement évaporatif direct et le second dispositif de refroidissement évaporatif direct, puis circule depuis le premier orifice de liquide vers le trajet d'écoulement de liquide de l'un du premier échangeur thermique de déshumidification ou du second échangeur thermique de déshumidification afin d'absorber la chaleur d'adsorption générée pendant la déshumidification, l'air ambiant ou une partie du flux d'air provenant de l'entrée d'air étant évacué après échange de chaleur et de masse avec le fluide caloporteur liquide dans le premier dispositif de refroidissement évaporatif direct, et le flux d'air provenant de l'entrée d'air étant évacué après échange de chaleur et de masse avec le fluide caloporteur liquide dans le second dispositif de refroidissement évaporatif direct.

10. Système de refroidissement selon l'une quelconque des revendications 6 à 9, dans lequel le système de refroidissement comprend en outre : un dispositif de réfrigération mécanique (5) comprenant un compresseur (251), un condenseur (252), un dispositif de détente (53) et un évaporateur (54) raccordés successivement ;
dans lequel le système de refroidissement est apte à fonctionner dans un mode de refroidissement naturel, un mode de refroidissement naturel auxiliaire, un mode de réfrigération collaborative, ou un mode de réfrigération mécanique, où seul le dispositif de refroidissement naturel est en fonctionnement dans le mode de refroidissement naturel, le module de prétraitement et le dispositif de refroidissement naturel fonctionnent ensemble dans le mode de refroidissement naturel auxiliaire, le module de prétraitement, le dispositif de refroidissement naturel et le dispositif de réfrigération mécanique fonctionnent ensemble dans le mode de réfrigération collaborative, et seul le dispositif de réfrigération mécanique est en fonctionnement dans le mode de réfrigération mécanique ;
dans lequel le système de refroidissement détermine un mode de fonctionnement sur la base de la température et de l'humidité ambiantes ;
éventuellement, l'air chauffé par la charge est mélangé avec de l'air ambiant éventuel, puis est acheminé vers le premier échangeur thermique de déshumidification ou le second échangeur thermique de déshumidification après passage à travers le condenseur du dispositif de réfrigération mécanique ;
dans lequel, en fonctionnement, le module de prétraitement bascule périodiquement entre le premier mode et le second mode.
